# EUROPEAN PATENT APPLICATION

(11) **EP 4 831 237 A1**
(43) Date of publication of application: **28.10.2026**
(21) Application number: 24907906.2
(22) Date of filing: 04.12.2024
(51) Int. Cl.: C08L 23/08, C08L 23/06, C08J 5/18, H10F 19/80

(54) **ENCAPSULANT FILM COMPOSITION AND ENCAPSULANT FILM COMPRISING SAME**

(30) Priority: 22.12.2023 KR 20230189950
(71) Applicant: LG Chem, Ltd., Seoul 07336 (KR)
(72) Inventor: KIM, Jong Won, Daejeon 34122 (KR); PARK, In Sung, Daejeon 34122 (KR); CHOE, Ik Je, Daejeon 34122 (KR); GWAK, Rae Keun, Daejeon 34122 (KR); JEON, Min Hong, Daejeon 34122 (KR); WOO, Ji Yoon, Daejeon 34122 (KR)
(74) Representative: Vossius & Partner Patentanwälte Rechtsanwälte mbB
(86) International application number: PCT/KR2024/019727
(87) International publication number: WO 2025/135622

(57) **Abstract**

The present invention relates to a composition for an encapsulant film comprising one or more olefin-based polymers and polyethylene, an encapsulant film comprising the same and a solar cell module, wherein a crystal distribution width of high-crystal and medium-crystal portions is maintained at 22°C or higher, so that adhesive strength and light transmittance are maintained while creep phenomenon is minimized, thereby minimizing deformation even using for a long time.

## Description

### TECHNICAL FIELD

### Cross-reference to Related Applications

This application claims the benefit of Korean Patent Application No. 10-2023-0189950, filed on December 22, 2023, in the Korean Intellectual Property Office, the contents of which are incorporated herein by reference.

### Technical Field

The present invention relates to a composition for an encapsulant film and an encapsulant film comprising the same.

### BACKGROUND ART

Recently, interest in renewable energy and clean energy has been increasing due to global environmental problems and depletion of fossil fuels. Among them, optoelectronic devices that utilize light, for example, photovoltaic cells, light-emitting diodes (LEDs), or organic light-emitting diodes (OLEDs), are attracting attention as pollution-free energy devices. In particular, photovoltaic cells such as solar cells are rapidly spreading to residential and industrial uses.

A photovoltaic cell is a device that converts light into electrical energy, and since the photovoltaic cell generally needs to be exposed to the external environment for a long time so as to easily absorb light, the photovoltaic cell is manufactured in the form of a unit with various packaging processes to protect the internal devices, and such a unit is usually called a photovoltaic module.

In the case of a general solar cell module, two encapsulant sheets wrapping a solar cell are formed between a surface-side glass substrate and a rear protective film, which is a back-side protective member. Such a solar cell module is manufactured by sequentially laminating a glass substrate, encapsulant sheet, solar cell, encapsulant sheet, and rear protective film, and then performing a pressurization and degassing process in the upper and lower directions while the encapsulant sheets are completely melted by heating/pressurization to secure sufficient mobility of a polymer.

Perovskite materials, which are receiving much attention as light-absorbing materials for solar cells, have poor thermal stability and are greatly affected by external environments such as temperature and humidity, and there is a problem that phase transition occurs at high temperatures or that photoelectric conversion efficiency deteriorates rapidly if humidity is high.

Therefore, the development of an encapsulant composition that may maintain creep characteristics and adhesive strength while being attached by low-temperature lamination for compounds weak to high temperatures such as perovskite.

### DISCLOSURE OF THE INVENTION

### TECHNICAL PROBLEM

An object of the present invention is to provide a composition for an encapsulant film having excellent creep characteristics while maintaining adhesive strength and light transmittance by maintaining wide crystallinity distribution and a crystal distribution width of high-crystal and medium-crystal portions of 22°C or higher.

Another object of the present invention is to provide an encapsulant film formed with the composition for an encapsulant film.

### TECHNICAL SOLUTION

1. The present invention provides a composition for an encapsulant film, comprising a polyolefin-based composite satisfying the conditions (1) to (3) below, wherein the polyolefin-based composite comprises one or more olefin-based polymers and polyethylene.
   (1) a density is 0.855 g/cc or more, and 0.895 g/cc or less,
   (2) a melt index (MI, 190°C, 2.16 kg load condition) is 0.3 dg/min or more, and 40.0 dg/min or less, and
   (3) if measured by differential scanning calorimetry successive self-nucleation and annealing (DSC-SSA),
      a) $T \left(90\right) - T \left(75\right) > 21.5 ° C ,$
      b) $T \left(95\right) - T \left(90\right) < 18 ° C ,$ and
      c) $T \left(98\right) - T \left(95\right) < 10 ° C ,$
   where T(98), T(95), T(90), and T(75) are temperatures at which heat capacity reaches 98%, 95%, 90%, and 75%, respectively, if a temperature-heat capacity curve measured by differential scanning calorimetry successive self-nucleation and annealing (DSC-SSA) is fractionated.
2. The present invention provides the composition for an encapsulant film according to 1, wherein the composition for an encapsulant film satisfies condition (4) below.
   (4) a melt flow rate ratio (MFRR, MI₁₀/MI_{2.16}) is 7.5 or more, and 9.5 or less.
3. The present invention provides the composition for an encapsulant film according to 1 or 2, wherein the composition for an encapsulant film satisfies condition (5) below.
   (5) a weight average molecular weight is 10,000 g/mol or more, and 500,000 g/mol or less.
4. The present invention provides the composition for an encapsulant film according to any one of 1 to 3, wherein the polyolefin-based composite satisfies condition (6) below.
   (6) molecular weight distribution is 1.5 or more, and 3.0 or less.
5. The present invention provides the composition for an encapsulant film according to any one of 1 to 4, wherein T(95) is 100°C or higher, and 110°C or lower.
6. The present invention provides the composition for an encapsulant film according to any one of 1 to 5, wherein T(90) is 85.9°C or higher.
7. The present invention provides the composition for an encapsulant film according to any one of 1 to 6, wherein the polyethylene is comprised in 1 part by weight or more, and 5 parts by weight or less based on 100 parts by weight of the olefin-based polymer.
8. The present invention provides the composition for an encapsulant film according to any one of 1 to 7, wherein the one or more olefin-based polymers comprise a first olefin-based polymer and a second olefin-based polymer, and
   a weight ratio of the first olefin-based polymer and the second olefin-based polymer is 1:0.1 or more, and 1 or less.
9. The present invention provides the composition for an encapsulant film according to any one of 1 to 8, wherein the olefin-based polymer is a copolymer of ethylene and an alpha-olefin comonomer.
10. The present invention provides the composition for an encapsulant film according to 9, wherein the alpha-olefin comonomer is an alpha-olefin comonomer of 3 to 12 carbon atoms.
11. The present invention provides the composition for an encapsulant film according to 9 or 10, wherein the alpha-olefin comonomer comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, norbornene, norbornadiene, ethylidenenorbornene, phenylnorbornene, vinylnorbornene, dicyclopentadiene, 1,4-butadiene, 1,5-pentadiene, 1,6-hexadiene, styrene, alpha-methylstyrene, divinylbenzene, and 3-chloromethylstyrene.
12. The present invention provides an encapsulant film formed using the composition for an encapsulant film according to any one of 1 to 11.
13. The present invention provides a solar cell module comprising the encapsulant film of 12.

### ADVANTAGEOUS EFFECTS

The composition for an encapsulant film of the present invention has wide crystallinity distribution, and the crystal distribution width of high-crystal and medium-crystal portions is maintained at 22°C or higher, so that the encapsulant film formed thereby has excellent adhesive strength and light transmittance while minimizing creep phenomenon, thereby ensuring stability.

### BRIEF DESCRIPTION OF DRAWINGS

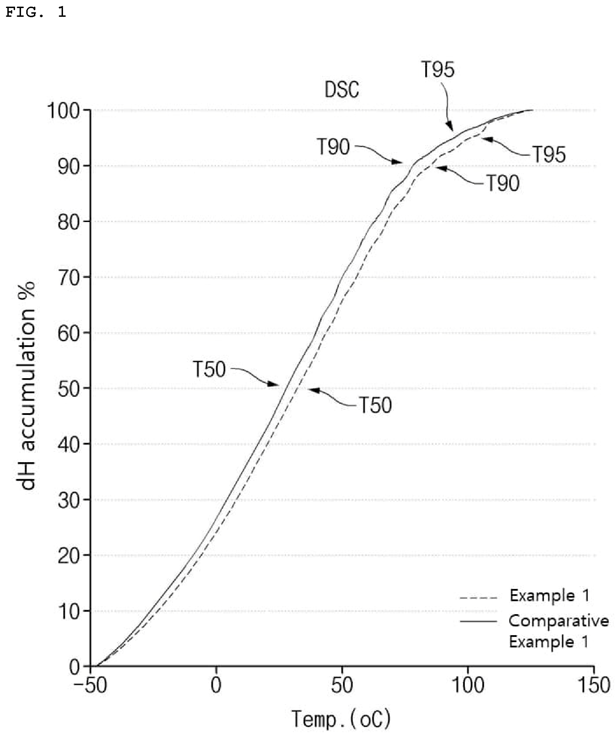

FIG. 1 is a graph showing the results of measurement using differential scanning calorimetry successive self-nucleation and annealing (SSA) for the polyolefin compositions of Example 1 and Comparative Example 1 in the present invention.

### BEST MODE FOR CARRYING OUT THE INVENTION

Hereinafter, the present invention will be described in more detail to assist the understanding of the present invention.

It will be understood that words or terms used in the present disclosure and claims shall not be interpreted as the meaning defined in commonly used dictionaries, but should be interpreted as having a meaning that is consistent with their meaning in the technical idea of the invention, based on the principle that an inventor may properly define the meaning of the words or terms to best explain the invention.

The term "polymer" used in the specification means a polymer compound prepared by polymerization of the same or different types of monomers. The generic term "polymer" includes the terms "homopolymer", "copolymer", "terpolymer" as well as "interpolymer." The term "interpolymer" means a polymer prepared by polymerization of two or more different types of monomers. The generic term "interpolymer" includes the term "copolymer" (which is commonly used to refer to a polymer prepared from two different types of monomers) as well as the term "terpolymer" (which is commonly used to refer to a polymer prepared from three different types of monomers). The terpolymer includes polymers prepared by polymerization of four or more types of monomers.

### [Composition for Encapsulant Film]

The present invention relates to a composition for an encapsulant film, which comprises a polyolefin-based composite satisfying the conditions of (1) to (3) below, wherein the polyolefin-based composite comprises one or more olefin-based polymers and polyethylene.

The polyolefin-based composite has (1) a density of 0.855 g/cc or more, and 0.895 g/cc or less. The density may refer to a density measured according to ASTM D-792. Specifically, the density of the composition for an encapsulant film may be 0.855 g/cc or more, 0.860 g/cc or more, 0.865 g/cc or more, 0.870 g/cc or more, and may also be 0.895 g/cc or less, 0.890 g/cc or less, 0.885 g/cc or less.

In the present invention, a catalyst composition including a transition metal compound having a specific structure is used, and a large amount of comonomer may be introduced. As a result, the composition for an encapsulant film according to an embodiment of the present invention may have a low density as described above, and thus may exhibit excellent light transmittance and low-temperature adhesive performance. More specifically, the composition for an encapsulant film may have a density of 0.855 g/cc or more, and 0.895 g/cc or less, and in this case, by controlling the density to the above range of density, the effect of maintaining physical properties such as adhesive strength and light transmittance and improving creep phenomenon is more remarkable.

In addition, the polyolefin-based composite has (2) a melt index (MI, 190°C, 2.16 kg load condition) of 0.3 dg/min or more, and 40.0 dg/min or less. Specifically, the melt index of the composition for an encapsulant film may be 0.3 dg/min or more, 0.5 dg/min or more, 1.0 dg/min or more, 1.5 dg/min or more, 2.0 dg/min or more, and further may be 40.0 dg/min or less, 35.0 dg/min or less, 30.0 dg/min or less, 25.0 dg/min or less, 20.0 dg/min or less, 15.0 dg/min or less, 10.0 dg/min or less, 9.0 dg/min or less, 8.0 dg/min or less, 7.0 dg/min or less, 6.0 dg/min or less, 5.0 dg/min or less, 4.5 dg/min or less, or 4.0 dg/min or less. The melt index may be controlled by controlling the amount of the comonomer of a catalyst used in the process of polymerizing the olefin-based polymer, and affect the mechanical properties, impact strength, and formability of the olefin-based polymer.

In addition, if the melt index is within the range, melt flowability suitable for forming an encapsulant film for a solar cell may be achieved.

In addition, the polyolefin-based composite has (3) if measured by differential scanning calorimetry successive self-nucleation and annealing (DSC-SSA), a) T(90)-T(75)>21.5°C, b) T(95)-T(90)<18°C, and c) T(98)-T(95)<10°C. Specifically, T(90)-T(75) may be 22°C or higher, 22.5°C or higher, or 23°C or higher, T(95)-T(90) may be 17.9°C or lower, 17.8°C or lower, 17.7°C or lower, 17.6°C or lower, or 17.5°C or lower, and T(98)-T(95) may be 9.9°C or lower, 9.8°C or lower, 9.7°C or lower, 9.6°C or lower, or 9.5°C or lower. Here, T(98), T(95), T(90), and T(75) are temperatures at which the heat capacity reaches 98%, 95%, 90%, and 75%, respectively, when a temperature-heat capacity curve measured by differential scanning calorimetry successive self-nucleation and annealing (DSC-SSA) is fractionated.

The crystal distribution of the polyolefin-based composite of the present invention may be known through T(90)-T(75), T(95)-T(90), and T(98)-T(95). The degree of distribution of high crystals, medium crystals, and low crystals may be known through T(90)-T(75), T(95)-T(90), and the distribution of high crystals within the high-crystal region may be known through T(98)-T(95). If T(90)-T(75), T(95)-T(90), and T(98)-T(95) satisfy the ranges, it means that high crystals, medium crystals, and low crystals are evenly distributed in the polyolefin-based composite of the present invention, and since each crystal does not exist separately but is distributed together in some sections, they firmly hold each other and may maintain the cohesion and adhesiveness of the polyolefin-based composite. On the other hand, if T(90)-T(75), T(95)-T(90), or T(98)-T(95) is deviated from the ranges and is too large or too small, high crystals, medium crystals, and low crystals exist separately, so that the crystal distribution is separated and does not adhere, or the intervals therebetween are too narrow to act as one crystal, so that the crystals melt or break at once, and the creep phenomenon may occur more frequently.

The polyolefin-based composite may be prepared, for example, by using two types of catalysts having different activities, copolymerization, and characteristics at a specific temperature in one reactor, and additionally adding polyethylene, which is responsible for high crystallinity, so that a section where high crystals, medium crystals and low crystals are distributed together is wide, while having crystallinity distribution that achieves each property. In this way, the polyolefin composition of the present invention does not have distribution where low crystals, medium crystals and high crystals exist separately, but rather the crystals are distributed so that, even in small quantities, they are distributed together like a bridge to have a connecting section from each other, so as to firmly hold each other to achieve not only excellent cohesion and adhesiveness but also minimized creep phenomenon.

T(95) of the polyolefin-based composite may be 100°C or higher, and 110°C or lower. Specifically, T(95) may be 101°C or higher, 102°C or higher, 103°C or higher, and also may be 109°C or lower, 108°C or lower, 107°C or lower, 106°C or lower, 105°C or lower, and 104°C or lower. If T(95) satisfies the range, a section distributed together with medium crystals is formed and may be connected with the medium crystals, so that the creep phenomenon may be minimized.

In addition, T(90) of the polyolefin-based composite may be 85.9°C or higher. Specifically, T(90) may be 86°C or higher, 86.1°C or higher, 86.2°C or higher, and also may be 100°C or lower, 95°C or lower, and 90°C or lower. Since T(90) satisfies the range, a section that is distributed together with medium crystals is formed and may be connected with the medium crystals, so that the creep phenomenon may be minimized.

In addition, the polyolefin-based composite of the present invention may satisfy the conditions (4) to (6) below.

The polyolefin-based composite may have (4) a melt flow rate ratio (MFRR, MI₁₀/MI_{2.16}) of 7.5 or more, and 9.5 or less. The melt flow rate ratio may be obtained by dividing the melt index measured under the conditions of 190°C and 10 kg load by the melt index measured under the conditions of 190°C and 2.16 kg load. Specifically, the melt flow rate ratio may be 7.5 or more, 7.6 or more, 7.7 or more, 7.8 or more, 7.9 or more, and also 9.5 or less, 9.4 or less, 9.3 or less, 9.2 or less, 9.1 or less.

If the polyolefin-based composite satisfies the melt flow rate ratio of the range, the adhesive properties of the composition for an encapsulant film of the present invention including the same and a film manufactured using the same may be improved.

The polyolefin-based composite may have (5) a weight average molecular weight (Mw) of 10,000 g/mol or more, and 500,000 g/mol or less, specifically, 15,000 g/mol or more, 20,000 g/mol or more, 25,000 g/mol or more, and also 450,000 g/mol or less, 400,000 g/mol or less, 350,000 g/mol or less, 300,000 g/mol or less, 250,000 g/mol or less, 200,000 g/mol or less.

The (6) molecular weight distribution of the polyolefin-based composite may be 1.5 or more, and 3.0 or less. The molecular weight distribution is a ratio (Mw/Mn) of a weight average molecular weight (Mw) and a number average molecular weight (Mn). The molecular weight distribution of the polyolefin composition may specifically be 1.6 or more, 1.7 or more, 1.8 or more, 1.9 or more, 2.0 or more, and may also be 2.9 or less, 2.8 or less, 2.7 or less, 2.6 or less, 2.5 or less, 2.4 or less, 2.3 or less.

Since the weight average molecular weight and molecular weight distribution of the polyolefin-based composite of the present invention satisfy the ranges, the adhesiveness, optical properties, and mechanical properties of the composition for an encapsulant film of the present invention including the same and the film manufactured using the same may be improved.

In the polyolefin-based composite of the present invention, the polyethylene may be included in an amount of 1 part by weight or more, and 5 parts by weight or less based on 100 parts by weight of the olefin-based polymer. Specifically, the polyethylene may be included in an amount of 1 part by weight or more, 1.5 parts by weight or more, 1.7 parts by weight or more, 1.9 parts by weight or more, or 2 parts by weight or more, based on 100 parts by weight of the olefin-based polymer, and may also be included in an amount of 5 parts by weight or less, 4.5 parts by weight or less, 4 parts by weight or less, 3.5 parts by weight or less, 3 parts by weight or less, or 2.5 parts by weight or less.

By including the polyethylene in the range, the creep resistance and adhesiveness are improved, and if the polyethylene is included in an amount exceeding 5 parts by weight, optical properties may deteriorate.

The polyethylene may have a density of 0.90 g/cm³ or more, and 0.95 g/cm³ or less, as measured by ASTM D1505. Specifically, the density of the polyethylene may be 0.91 g/cm³ or more, or 0.92 g/cm³ or more, and may also be 0.94 g/cm³ or less, or 0.93 g/cm³ or less.

In addition, the polyethylene may have a melt index of 0.5 g/10 min or more, and 2.5 g/10 min or less as measured by ASTM D1238 (190°C, 2.16 kg load conditions). Specifically, the melt index of the polyethylene may be 0.6 g/10 min, 0.7 g/10 min, 0.8 g/10 min, 0.9 g/10 min, 1 g/10 min or more, and may also be 2.4 g/10 min or less, 2.3 g/10 min or less, 2.2 g/10 min or less, 2.1 g/10 min or less.

By using the polyethylene having the properties, it may be well mixed with the olefin-based polymer of the present invention, and the effect of improving the creep characteristics of the composition for an encapsulant film of the present invention and the film manufactured using the same may be obtained.

By mixing and using the polyethylene having physical properties described above with the olefin-based polymer, the optical properties and adhesive properties of the olefin-based polymer having low and medium crystals may be maintained, while improving resistance in creep phenomenon by using polyethylene having high crystals.

In the polyolefin-based composite of the present invention, the one or more olefin-based polymers may include a first olefin-based polymer and a second olefin-based polymer. In this case, the weight ratio of the first olefin-based polymer and the second olefin-based polymer may be 1:0.1 or more, and 1 or less. Specifically, the weight ratio of the first olefin-based polymer and the second olefin-based polymer may be 1:0.1 or more, 0.2 or more, 0.3 or more, 0.4 or more, and may also be 1 or less, 0.9 or less, 0.8 or less, 0.7 or less.

If the first olefin-based polymer and the second olefin-based polymer satisfy the range, a significant improvement in creep phenomenon may be exhibited while maintaining light transmittance, and if the first olefin-based polymer and the second olefin-based polymer are used in a ratio smaller or larger than the range, a defect in the solar module may occur due to the occurrence of creep phenomenon, or a decrease in the efficiency of the solar module may occur due to low light transmittance characteristics.

The olefin-based polymer may be a copolymer of ethylene and an alpha-olefin comonomer. The alpha-olefin comonomer may specifically be an alpha-olefin comonomer of 3 to 12 carbon atoms. For example, the alpha-olefin comonomer may be one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, norbornene, norbornadiene, ethylidenenorbornene, phenylnorbornene, vinylnorbornene, dicyclopentadiene, 1,4-butadiene, 1,5-pentadiene, 1,6-hexadiene, styrene, alpha-methylstyrene, divinylbenzene, and 3-chloromethylstyrene.

If the olefin-based polymer is a copolymer of ethylene and alpha-olefin, the amount of the alpha-olefin may be 90 wt% or less, more specifically 70 wt% or less, even more specifically 5 wt% to 60 wt%, and even more specifically 20 wt% to 50 wt% based on the total weight of the copolymer.

The olefin-based polymer according to an embodiment of the present invention may be prepared through a continuous solution polymerization reaction in the presence of a metallocene catalyst composition including one or more transition metal compounds in a single reactor. Accordingly, the olefin-based polymer according to an embodiment of the present invention does not form a block that is formed by the linear connection of two or more repeating units derived from any monomers, among monomers constituting the polymer in the polymer. That is, the olefin-based polymer according to the present invention does not include a block copolymer, and may be selected from the group consisting of a random copolymer, an alternating copolymer, and a graft copolymer, and more specifically, may be a random copolymer.

Specifically, the olefin-based copolymer of the present invention may be obtained by a preparation method including a step of polymerizing an olefin-based monomer in the presence of a catalyst composition for olefin polymerization, including a transition metal compound of Formula 1 below (a first transition metal compound) and a transition metal compound of Formula 2 below (a second transition metal compound) in an equivalent ratio of 1:0.1 or more, and 5 or less. The equivalent ratio of the transition metal compounds of Formulas 1 and 2 may be specifically 1:0.1 or more, 0.2 or more, 0.3 or more, 0.4 or more, and may also be 1:5 or less, 4.5 or less, 4 or less, 3.5 or less, 3 or less, and 2.5 or less. By using the transition metal compound of Formula 1 and the transition metal compound of Formula 2 together in the above range, an olefin-based copolymer having crystallinity distribution that allows excellent adhesion and optical properties while minimizing creep phenomenon may be obtained.

However, in the preparation of the olefin-based polymer according to an embodiment of the present invention, the structural range of the first transition metal compound and the second transition metal compound below is not limited to a specific disclosure form, and it should be understood to include all modifications, equivalents, and substitutes in the spirit and technical scope of the present invention.

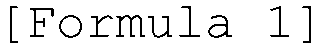

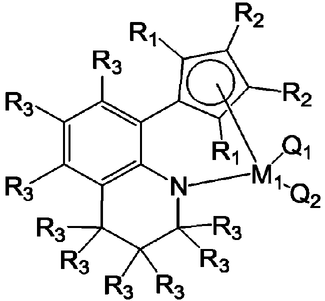

In Formula 1,
R₁ are the same or different from each other, and each independently hydrogen, alkyl having 1 to 20 carbon atoms, alkenyl having 2 to 20 carbon atoms, aryl, silyl, alkylaryl, arylalkyl, or a metalloid radical of a Group 4 metal, substituted with hydrocarbyl, wherein two R₁ may be connected to each other by an alkylidine radical including alkyl having 1 to 20 carbon atoms or an aryl radical having 6 to 20 carbon atoms to form a ring;
R₂ are the same or different from each other, and each independently hydrogen; halogen; alkyl having 1 to 20 carbon atoms; aryl; alkoxy; aryloxy; an amido radical, and two or more R₂ may be connected to each other to form an aliphatic ring or an aromatic ring;
R₃ are the same or different from each other, and each independently hydrogen; halogen; alkyl having 1 to 20 carbon atoms; or an aliphatic or aromatic ring containing nitrogen, substituted or unsubstituted with an aryl radical, and if the substituents are plural, two or more substituents among the substituents may be connected to each other to form an aliphatic or aromatic ring;
M₁ is a Group 4 transition metal; and
Q₁ and Q₂ are each independently halogen; alkyl having 1 to 20 carbon atoms; alkenyl; aryl; alkylaryl; arylalkyl; alkyl amido having 1 to 20 carbon atoms; aryl amido; or an alkylidene radical having 1 to 20 carbon atoms.

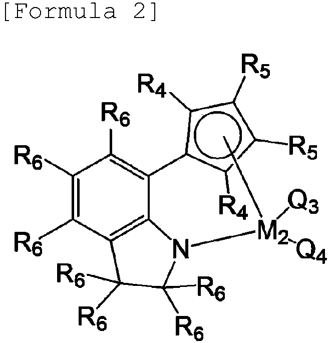

In Formula 2,
R₄ are the same or different from each other, and each independently hydrogen, alkyl having 1 to 20 carbon atoms, alkenyl having 2 to 20 carbon atoms, aryl, silyl, alkylaryl, arylalkyl, or a metalloid group of a Group 4 metal, substituted with hydrocarbyl, wherein two R₄ may be connected to each other by alkylidine including alkyl having 1 to 20 carbon atoms or aryl having 6 to 20 carbon atoms to form a ring;
R₅ are the same or different from each other, and each independently hydrogen; halogen; alkyl having 1 to 20 carbon atoms; aryl; alkoxy; aryloxy; amido, wherein R₅ may be connected to each other to form an aliphatic ring or an aromatic ring;
R₆ are the same or different from each other, and each independently hydrogen; halogen; alkyl having 1 to 20 carbon atoms; or an aliphatic or aromatic ring containing nitrogen, substituted or unsubstituted with aryl, and if the substituents are plural, two or more substituents among the substituents may be connected to each other to form an aliphatic or aromatic ring;
M₂ is a Group 4 transition metal; and
Q₃ and Q₄ are each independently halogen; alkyl having 1 to 20 carbon atoms; alkenyl; aryl; alkylaryl; arylalkyl; alkyl amido having 1 to 20 carbon atoms; aryl amido; or alkylidene having 1 to 20 carbon atoms.

Meanwhile, the catalyst composition may further include a cocatalyst to activate the transition metal compound of Formula 1 or 2.

The cocatalyst may be a borate-based compound in the form of, for example, a trisubstituted ammonium salt, a dialkyl ammonium salt, or a trisubstituted phosphonium salt, and more specifically, borate-based compounds in the form of trialkylammonium salts such as dimethylanilinium tetrakis(pentafluorophenyl)borate, trimethylammonium tetraphenylborate, methyldioctadecylammonium tetraphenylborate, triethylammonium tetraphenylborate, tripropylammonium tetraphenylborate, tri(n-butyl)ammonium tetraphenylborate, methyltetradecyclooctadecylammonium tetraphenylborate, N,N-dimethylanilinium tetraphenylborate, N,N-diethylanilinium tetraphenylborate, N,N-dimethyl(2,4,6-trimethylanilinium)tetraphenylborate, trimethylammonium tetrakis(pentafluorophenyl)borate, methylditetradecylammonium tetrakis(pentaphenyl)borate, methyldioctadecylammonium tetrakis(pentafluorophenyl)borate, triethylammonium, tetrakis(pentafluorophenyl)borate, tripropylammonium tetrakis(pentafluorophenyl)borate, tri(n-butyl)ammonium tetrakis(pentafluorophenyl)borate, tri(sec-butyl)ammonium tetrakis(pentafluorophenyl)borate, N,N-dimethylanilinium tetrakis(pentafluorophenyl)borate, N,N-diethylanilinium tetrakis(pentafluorophenyl)borate, N,N-dimethyl(2,4,6-trimethylanilinium)tetrakis(pentafluorophenyl)borate, trimethylammoniumtetrakis(2,3,4,6-tetrafluorophenyl)borate, triethylammonium tetrakis(2,3,4,6-tetrafluorophenyl)borate, tripropylammonium tetrakis(2,3,4,6-tetrafluorophenyl)borate, tri(n-butyl)ammonium tetrakis(2,3,4,6-,tetrafluorophenyl)borate, dimethyl(t-butyl)ammonium tetrakis(2,3,4,6-tetrafluorophenyl)borate, N,N-dimethylanilium tetrakis(2,3,4,6-tetrafluorophenyl)borate, N,N-diethylanilium tetrakis(2,3,4,6-tetrafluorophenyl)borate, or N,N-dimethyl-(2,4,6-trimethylanilium)tetrakis-(2,3,4,6-tetrafluorophenyl) borate; borate-based compounds in the form of dialkylammonium salts such as dioctadecylammonium tetrakis(pentafluorophenyl)borate, ditetradecylammonium tetrakis(pentafluorophenyl)borate, or dicyclohexylammonium tetrakis(pentafluorophenyl)borate; or borate-based compounds in the form of trisubstituted phosphonium salts such as triphenylphosphonium tetrakis(pentafluorophenyl)borate, methyldioctadecylphosphonium tetrakis(pentafluorophenyl)borate, or tri(2,6-, dimethylphenyl)phosphoniumtetrakis(pentafluorophenyl)borate.

The cocatalyst may be used in an appropriate amount so that the activation of the transition metal compound of Formula 1 or the transition metal compound of Formula 2 may sufficiently proceed. For example, the cocatalyst may be used in a molar ratio of 1 to 5 based on the total number of moles of the transition metal compound of Formula 1 and the transition metal compound of Formula 2, and specifically, the molar ratio may be 1.2 or more, 1.4 or more, 1.6 or more, 1.8 or more, and 2 or more, and also may be 4.8 or less, 4.6 or less, 4.4 or less, 4.2 or less, and 4 or less.

By using the cocatalyst in the range, the molecular weight distribution of the finally prepared ethylene/alpha-olefin copolymer may be more uniform, and the polymerization activity may be improved.

In addition, the catalyst composition may further include a scavenger compound for removing moisture in the reactor during the polymerization reaction. Specific examples of the scavenger compound include triisobutylaluminum, trialkylaluminum, dialkyl aluminum halides, alkyl aluminum dihalides, aluminum dialkyl hydrides, or alkyl aluminum sesqui halides.

The scavenger compound may be continuously introduced into the reactor, and the content thereof may be appropriately adjusted and introduced by a person skilled in the art depending on the reaction conditions or the type of a catalyst. For example, the scavenger compound may be introduced in an amount of 10 ppm or more, and 1000 ppm or less relative to the total flow rate of a hexane solvent, ethylene, and alpha-olefin, introduced during the polymerization reaction, and more specifically, may be introduced in an amount of 50 ppm or more, 100 ppm or more, 150 ppm or more, 200 ppm or more, 250 ppm or more, 300 ppm or more, and may also be introduced in an amount of 900 ppm or less, 800 ppm or less, 700 ppm or less, 600 ppm or less, 500 ppm or less, 400 ppm or less.

The composition for an encapsulant film of the present invention may further include one or more selected from the group consisting of a crosslinking agent, a crosslinking auxiliary agent, a silane coupling agent, a light stabilizer, a UV absorber, and a thermal stabilizer.

The crosslinking agent may serve as an initiator to initiate a reaction in which an unsaturated silane compound is grafted onto the composition for an encapsulant film. Through the grafting of the silane compound, the glass adhesion properties of a final product, for example, a film or an encapsulant sheet, may be improved.

The crosslinking agent may be, for example, one or two or more selected from the group consisting of an organic peroxide, a hydroperoxide, and an azo compound.

The crosslinking agent is included in an amount of 0.01 to 1 parts by weight, for example, 0.05 to 0.55, 0.1 to 0.5, or 0.15 to 0.45 parts by weight, based on 100 parts by weight of the composition for an encapsulant film. If the crosslinking agent is included in an amount of less than 0.01 parts by weight, the effect of improving glass adhesion properties may be insignificant, and the crosslinking agent is included in an amount greater than 1 part by weight, the moldability of final products such as an encapsulant sheet may be reduced, which may cause problems of process restrictions, and may affect the physical properties of the encapsulant.

The silane coupling agent may be, for example, one or more selected from the group consisting of vinyltrimethoxysilane (VTMS), 3-aminopropyltriethoxysilane (APS), N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO).

The silane coupling agent may be included in an amount of 0.1 to 4 parts by weight, more specifically, 0.5 to 3 parts by weight, based on 100 parts by weight of the composition for an encapsulant film. If used in an amount of less than 0.1, the adhesion to glass during the manufacture of a solar module is poor, which makes the penetration of moisture easy, and thus the long-term performance of the module may not be guaranteed. If the amount used is in an amount of 4 parts by weight or more, the melt index increases and the molecular weight decreases due to the destruction of a polymer structure, undesirably.

In addition, the composition for an encapsulant film may additionally include one or more additives selected from a light stabilizer, a UV absorber, and a thermal stabilizer, as needed.

The light stabilizer may play a role in preventing photooxidation by capturing an active species of the photothermal initiation of a resin, depending on the application of the composition. The type of the light stabilizer that may be used is not particularly limited, and for example, a known compound such as a hindered amine compound or a hindered piperidine compound may be used.

The UV absorber may play a role in preventing the active species of the photothermal initiation of the resin composition from being excited by absorbing ultraviolet rays from sunlight, etc. and converting them into harmless heat energy within the molecule, depending on the application of the composition. The specific type of the UV absorber that may be used is not particularly limited, and for example, one or a mixture of two or more types of inorganic UV absorbers of benzophenone-based, benzotriazole-based, acrylonitrile-based, metal complex-based, hindered amine-based, ultrafine titanium oxide, or ultrafine zinc oxide may be used.

In addition, examples of the thermal stabilizer include phosphorus-based thermal stabilizers such as tris(2,4-di-tert-butylphenyl)phosphite, bis[2,4-bis(1,1-dimethylethyl)-6-methylphenyl]ethyl ester phosphorous acid, tetrakis(2,4-di-tert-butylphenyl) [1,1-biphenyl]-4,4'-diylbisphosphonate, and bis(2,4-di-tert-butylphenyl)pentaerythritol diphosphite; lactone-based thermal stabilizers such as a reaction product of 8-hydroxy-5,7-di-tert-butyl-furan-2-one and o-xylene, and one or more thereof may be used.

The contents of the light stabilizer, UV absorber, and/or thermal stabilizer are not particularly limited. That is, the content of the additive may be appropriately selected in consideration of the purpose of the resin composition, the shape or density of the additive, etc., and may be appropriately adjusted within a range of 0.01 to 5 parts by weight based on 100 parts by weight of the total solid content of the composition for an encapsulant film.

In addition, the composition for an encapsulant film of the present invention may appropriately additionally include various additives known in the relevant field, in addition to the above components, depending on the purpose to which the resin component is applied.

In addition, the composition for an encapsulant film may be molded into various molded products by methods such as injection molding or extrusion, and specifically, may be used as an encapsulant for encapsulating elements in various optoelectronic devices, for example, solar cells, and may also be used as an industrial material applied to, for example, a lamination process with heating.

### [Encapsulant Film]

In addition, the present invention relates to an encapsulant film formed with the aforementioned composition for an encapsulant film.

The encapsulant film of the present invention may be manufactured by molding the aforementioned composition for an encapsulant film into a film or sheet shape. The molding method is not particularly limited, and for example, the encapsulant film may be manufactured by forming a sheet or film using a common process such as a T-die process or extrusion. For example, the manufacture of the encapsulant film may be performed as an in-situ process using a device in which the preparation of a modified resin composition using the composition for an encapsulant film and the process of forming a film or sheet, are connected to each other.

The thickness of the encapsulant film may be adjusted to about 10 to 2,000 µm, or about 100 to 1,250 µm, considering the support efficiency and breakage possibility of the element in the optoelectronic device, the weight reduction or workability of the device, and may be changed depending on the specific use.

### [Solar Cell Module]

In addition, the present invention provides a solar cell module including the encapsulant film. In the present invention, the solar cell module may have a configuration in which the gaps between the cells of the solar cell, arranged in series or in parallel are filled with the encapsulant film of the present invention, a glass surface is positioned on the side where sunlight strikes, and the back surface is protected with a back sheet, and various types and shapes of solar cell modules manufactured including the encapsulant film in the relevant technical field may all be applied to the present invention.

The glass surface may use tempered glass to protect the solar cell from external impact and prevent damage, and low iron tempered glass with a low iron content may be used to prevent reflection of sunlight and increase the transmittance of sunlight.

The back sheet is a weather-resistant film that protects the back surface of the solar cell module from the outside, and includes, for example, a fluorine-based resin sheet, a metal plate or metal foil of aluminum or the like, a cyclic olefin-based resin sheet, a polycarbonate-based resin sheet, a poly(meth)acrylic-based resin sheet, a polyamide-based resin sheet, a polyester-based resin sheet, a composite sheet in which a weather-resistant film and a barrier film are laminated or the like.

In addition, the solar cell module of the present invention may be manufactured without limitation according to a method known in the art, except for including the aforementioned encapsulant film.

The solar cell module of the present invention is manufactured using an encapsulant film with minimized creep phenomenon, and thus hardly undergoes deformation even if used for a long time and in an extreme environment (for example, maintaining durability even under conditions of a temperature of 85°C and a humidity of 85%), and has excellent durability because a delamination phenomenon is minimized, and may greatly suppress the occurrence of output reduction problems or the like.

### Examples

Hereinafter, the present invention will be described in more detail referring to examples. However, the examples are intended to illustrate the present invention, and the scope of the present invention is not limited thereto.

### [Preparation of Transition Metal Compound Catalyst]

### Preparation Example 1: Preparation of Transition Metal Compound 1

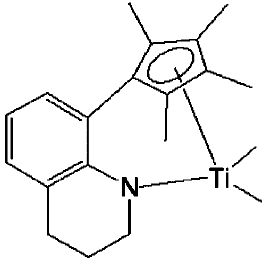

### (1) Preparation of 8-(2,3,4,5-tetramethyl-1,3-cyclopentadienyl)-1,2,3,4-tetrahydroquinoline

### (i) Preparation of lithium carbamate

1,2,3,4-Tetrahydroquinoline (13.08 g, 98.24 mmol) and diethyl ether (150 mL) were put in a Schlenk flask. The Schlenk flask was immersed in a -78°C low-temperature bath obtained using dry ice and acetone, and stirred for 30 minutes. Then, n-BuLi (39.3 mL, 2.5 M, 98.24 mmol) was injected using a syringe under a nitrogen atmosphere, and a pale yellow slurry was formed. Then, after stirring the flask for 2 hours, the temperature of the flask was raised to room temperature while removing butane gas produced. The flask was immersed again in a -78°C low-temperature bath to lower the temperature, and then CO₂ gas was added. As the carbon dioxide gas was added, the slurry disappeared and a transparent solution was formed. The flask was connected to a bubbler to remove the carbon dioxide gas and the temperature was raised to room temperature. After that, the excess CO₂ gas and solvent were removed under vacuum. After transferring the flask to a dry box, pentane was added, and resultant was stirred vigorously, and filtered to obtain a white solid compound, lithium carbamate. The white solid compound is coordinated with diethyl ether. In this case, the yield is 100%.
¹H NMR (C₆D₆, C₅D₅N): δ 1.90 (t, J = 7.2 Hz, 6H, ether), 1.50 (br s, 2H, quin-CH₂), 2.34 (br s, 2H, quin-CH₂), 3.25 (q, J = 7.2 Hz, 4H, ether), 3.87 (br, s, 2H, quin-CH₂), 6.76 (br d, J = 5.6 Hz, 1H, quin-CH) ppm
¹³C NMR (C₆D₆) : δ 24.24, 28.54, 45.37, 65.95, 121.17, 125.34, 125.57, 142.04, 163.09(C=O) ppm

### (ii) Preparation of 8-(2,3,4,5-tetramethyl-1,3-cyclopentadienyl)-1,2,3,4-tetrahydroquinoline

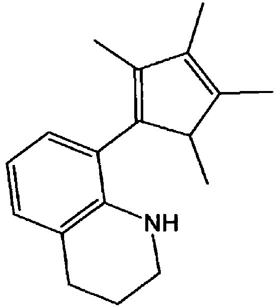

The lithium carbamate compound (8.47 g, 42.60 mmol) prepared in step (i) was put in a Schlenk flask. Then, tetrahydrofuran (4.6 g, 63.9 mmol) and 45 mL of diethyl ether were sequentially added. The Schlenk flask was immersed in a -20°C low-temperature bath obtained using acetone and a small amount of dry ice and stirred for 30 minutes, and then t-BuLi (25.1 mL, 1.7 M, 42.60 mmol) was added. In this case, the color of the reaction mixture changed to red. The mixture was stirred for 6 hours while maintaining the temperature at -20°C. A solution of CeCl₃·2LiCl (129 mL, 0.33 M, 42.60 mmol) dissolved in tetrahydrofuran and tetramethylcyclopentinone (5.89 g, 42.60 mmol) were mixed in a syringe, and then injected into the flask under a nitrogen atmosphere. The temperature of the flask was slowly raised to room temperature, and after 1 hour, the thermostatic bath was removed and the temperature was maintained at room temperature. Then, water (15 mL) was added to the flask, followed by addition of ethyl acetate and filtering to obtain a filtrate. The filtrate was transferred to a separatory funnel, and hydrochloric acid (2 N, 80 mL) was added thereto, followed by shaking for 12 minutes. Then, a saturated aqueous sodium bicarbonate solution (160 mL) was added to neutralize the solution, and an organic layer was extracted. Anhydrous magnesium sulfate was added to the organic layer to remove moisture, the resultant was filtered, and the filtrate was taken and the solvent was removed. The filtrate thus obtained was purified by column chromatography using hexane and ethyl acetate (v/v, 10:1) as a solvent to obtain a yellow oil. The yield was 40%.

¹H NMR (C₆D₆) : δ 1.00 (br d, 3H, Cp-CH₃), 1.63 - 1.73 (m, 2H, quin-CH₂), 1.80 (s, 3H, Cp-CH₃), 1.81 (s, 3H, Cp-CH₃), 1.85 (s, 3H, Cp-CH₃), 2.64 (t, J = 6.0 Hz, 2H, quin-CH₂), 2.84 - 2.90 (br, 2H, quin-CH₂), 3.06 (br s, 1H, Cp-H), 3.76 (br s, 1H, N-H), 6.77 (t, J = 7.2 Hz, 1H, quin-CH), 6.92 (d, J = 2.4 Hz, 1H, quin-CH), 6.94 (d, J = 2.4 Hz, 1H, quin-CH) ppm

### (2) Preparation of [(1,2,3,4-tetrahydroquinolin-8-yl)tetramethylcyclopentadienyl-eta5,kapa-N]titanium dimethyl

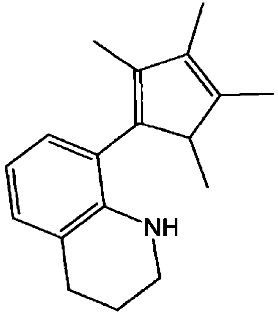

### (i) Preparation of [(1,2,3,4-tetrahydroquinolin-8-yl)tetramethylcyclopentadienyl-η5,κ-N]dilithium compound

In a dry box, 8-(2,3,4,5-tetramethyl-1,3-cyclopentadienyl)-1,2,3,4-tetrahydroquinoline (8.07 g, 32.0 mmol) prepared through step (1) and 140 mL of diethyl ether were put in a round bottom flask, and the temperature was lowered to -30°C, and then, n-BuLi (17.7 g, 2.5 M, 64.0 mmol) was slowly added while stirring. The reaction was performed for 6 hours while raising the temperature to room temperature. After that, a solid was obtained by filtration while washing several times with diethyl ether. The remaining solvent was removed by applying vacuum to obtain a dilithium compound (9.83 g) as a yellow solid. The yield was 95%.

¹H NMR (C₆D₆, C₅D₅N) : δ 2.38 (br s, 2H, quin-CH₂), 2.53 (br s, 12H, Cp-CH₃), 3.48 (br s, 2H, quin-CH₂), 4.19 (br s, 2H, quin-CH₂), 6.77 (t, J = 6.8 Hz, 2H, quin-CH), 7.28 (br s, 1H, quin-CH), 7.75 (brs, 1H, quin-CH) ppm

### (ii) Preparation of (1,2,3,4-tetrahydroquinolin-8-yl)tetramethylcyclopentadienyl-η⁵,κ-N]titanium dimethyl

In a dry box, TiCl₄·DME (4.41 g, 15.76 mmol) and diethyl ether (150 mL) were put in a round bottom flask, and MeLi (21.7 mL, 31.52 mmol, 1.4 M) was slowly added while stirring at -30°C. After stirring for 15 minutes, [(1,2,3,4-tetrahydroquinolin-8-yl)tetramethylcyclopentadienyl-ηη⁵,κ-N]dilithium compound (5.30 g, 15.76 mmol) prepared in step (i) was added to the flask. The temperature was raised to room temperature and stirred for 3 hours. After the reaction was completed, the solvent was removed by applying vacuum, and the resultant was dissolved in pentane, and filtered to obtain a filtrate. Through removing the pentane by vacuum, a dark brown compound (3.70 g) was obtained. The yield was 71.3%.

¹H NMR(C₆D₆): δ 0.59 (s, 6H, Ti-CH₃), 1.66 (s, 6H, Cp-CH₃), 1.69 (br t, J = 6.4 Hz, 2H, quin-CH₂), 2.05 (s, 6H, Cp-CH₃), 2.47 (t, J = 6.0 Hz, 2H, quin-CH₂), 4.53 (m, 2H, quin-CH₂), 6.84 (t, J = 7.2 Hz, 1H, quin-CH), 6.93 (d, J =7.6 Hz, quin-CH), 7.01 (d, J =6.8 Hz, quin-CH) ppm

¹³C NMR (C₆D₆) : δ 12.12, 23.08, 27.30, 48.84, 51.01, 119.70, 119.96, 120.95, 126.99, 128.73, 131.67, 136.21 ppm

### Preparation Example 2: Preparation of Transition Metal Compound 2

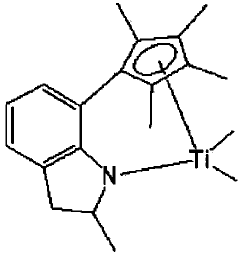

### (1) Preparation of 2-methyl-7-(2,3,4,5-tetramethyl-1,3-cyclopentadienyl)indoline

2-Methyl-7-(2,3,4,5-tetramethyl-1,3-cyclopentadienyl)indoline was prepared by the same method as (1) of Preparation Example 1, except that 2-methyl indoline was used instead of 1,2,3,4-tetrahydroquinoline in (1) of Preparation Example 1. The yield was 19%.

¹H NMR (C₆D₆): δ 6.97(d, J=7.2Hz, 1H, CH), δ 6.78(d, J=8Hz, 1H, CH), δ 6.67 (t, J=7.4Hz, 1H, CH), δ 3.94 (m, 1H, quinoline-CH), δ 3.51(br s, 1H, NH), δ 3.24-3.08(m, 2H, quinoline-CH₂, Cp-CH), δ 2.65 (m, 1H, quinoline-CH²), δ 1.89(s, 3H, Cp-CH₃), δ 1.84(s, 3H, Cp-CH₃), δ 1.82(s, 3H, Cp-CH₃), δ 1.13(d, J=6Hz, 3H, quinoline-CH₃), δ 0.93 (3H, Cp-CH₃) ppm.

### (2) Preparation of [(2-methylindolin-7-yl)tetramethylcyclopentadienyl-eta5,kapa-N]titanium dimethyl

(i) A dilithium salt compound (4 g of compound) coordinated with 0.58 equivalents of diethyl ether was obtained (1.37 g, 50%) through the same method as (2) (i) of Preparation Example 1, except for using 2-methyl-7-(2,3,4,5-tetramethyl-1,3-cyclopentadienyl)-indoline (2.25 g, 8.88 mmol) instead of 8-(2,3,4,5-tetramethyl-1,3-cyclopentadienyl)-1,2,3,4-tetrahydroquinoline.

¹H NMR (Pyridine-d8) : δ 7.22 (br s, 1H, CH), δ 7.18 (d, J=6Hz, 1H, CH), δ 6.32 (t, 1H, CH), δ 4.61(brs, 1H, CH), δ 3.54 (m, 1H, CH), δ 3.00 (m, 1H, CH), δ 2.35-2.12(m,13H, CH, Cp-CH3), δ 1.39(d, indoline-CH3) ppm.

(ii) A titanium compound was prepared using the dilithium salt compound (4 g of compound) (1.37 g, 4.44 mmol) prepared in (i) above through the same method as (2) (ii) of Preparation Example 1.

¹H NMR (C₆D₆): δ 7.01-6.96(m, 2H, CH), δ 6.82(t, J=7.4Hz, 1H, CH), δ 4.96 (m, 1H, CH), δ 2.88 (m, 1H, CH), δ 2.40 (m, 1H, CH), δ 2.02 (s, 3H, Cp-CH₃), δ 2.01(s, 3H, Cp-CH₃), δ 1.70(s, 3H, Cp-CH₃), δ 1.69(s, 3H, Cp-CH₃), δ 1.65(d, J=6.4Hz, 3H, indoline-CH₃), δ 0.71(d, J=10Hz, 6H, TiMe₂-CH₃) ppm.

### [Preparation of Ethylene/Alpha-olefin Copolymer]

### Preparation Example 3

A 1.5 L continuous process reactor was charged with a hexane solvent and butene at a weight ratio per unit time of 13:1 (kg/h), and the temperature at the top of the reactor was preheated to 160°C. A triisobutyl aluminum compound (350 ppm relative to the total flow rate of hexane solvent + butene + ethylene), a mixture of transition metal compounds obtained by mixing the transition metal compound 1 obtained in Preparation Example 1 and the transition metal compound 2 obtained in Preparation Example 2 in a molar ratio of 4:6 as a catalyst, and a dimethylanilinium tetrakis(pentafluorophenyl) borate cocatalyst were simultaneously added to the reactor at a molar ratio per unit time of the catalyst and the cocatalyst of 1:3 (µmol/min). Then, ethylene (0.87 kg/h) was injected into the reactor and a copolymerization reaction was performed by maintaining the temperature at 160°C for 30 minutes or more in a continuous process at a pressure of 89 bar to obtain a copolymer. After drying in a vacuum oven for 12 hours or more, the physical properties were measured.

### Preparation Examples 4 and 5

The copolymerization reaction was carried out using two transition metal catalysts in the same manner as in Preparation Example 3, and the ratios of the two transition metals in the catalysts were changed as shown in Table 1 below to carry out the copolymerization reaction, thereby obtaining copolymers.

**[Table 1]**

| Division | Transition metal ratio in catalyst (molar ratio) | |
|---|---|---|
| | Transition metal compound 1 | Transition metal compound 2 |
| Preparation Example 3 | 4 | 6 |
| Preparation Example 4 | 5 | 5 |
| Preparation Example 5 | 6 | 4 |

### [Manufacture of Encapsulant Film]

### Example 1

Polyethylene (produced by LG Chem, product name BF315) was added to the ethylene/alpha-olefin copolymer of Preparation Example 3, prepared above in an amount of 2 parts by weight based on 100 parts by weight of the ethylene/alpha-olefin copolymer, blended, and then extruded using a twin-screw extruder (70-210°C, 200 rpm), and finally the sample was pelletized using a pelletizer to prepare a polyolefin composition (polyolefin-based composite).

Thereafter, 500 g of the pellet was added to a Planetary Mixer preheated to 40°C, and based on 100 parts by weight of a composition for encapsulant film, a mixture liquid of 1.72 parts by weight of a silane coupling agent (vinyltrimethoxysilane (VTMS): γ-aminopropyltriethoxysilane = 9:1 weight ratio) and 0.09 parts by weight of an organic peroxide (2,5-dimethyl-2,5-di(tert-butylperoxy)hexane; C₁₆H₃₄O₄; ACros Co.) as an initiator was extruded to obtain a composition for an encapsulant film. The extruder was a twin-screw extruder and used at conditions of 70-210°C and 200 rpm. The composition for an encapsulant film prepared as above and the polyolefin composition were blended at a weight ratio of 1:2, and then injected into an extruder having a T-die-shaped discharge part to manufacture a film.

### Example 2

An encapsulant film was manufactured in the same manner as in Example 1, except that the ethylene/alpha-olefin copolymer of preparation Example 4 was used as an ethylene/alpha-olefin copolymer.

### Example 3

An encapsulant film was manufactured in the same manner as in Example 1, except that the ethylene/alpha-olefin copolymer of preparation Example 5 was used as an ethylene/alpha-olefin copolymer.

### Example 4

An encapsulant film was manufactured in the same manner as in Example 1, except that 60 wt% and 40 wt% of LC565 and LC385, respectively, product names of LG Chem, were used as ethylene/alpha-olefin copolymers.

### Example 5

An encapsulant film was manufactured in the same manner as in Example 1, except that 70 wt% and 30 wt% of LC565 and LC385, respectively, product names of LG Chem, were used as ethylene/alpha-olefin copolymers, and 2.5 parts by weight of the polyethylene was added based on 100 parts by weight of the ethylene/alpha-olefin copolymer.

### Comparative Example 1

An encapsulant film was manufactured in the same manner as in Example 1, except that only the ethylene/alpha-olefin copolymer of Preparation Example 3 was used without the addition of polyethylene.

### Comparative Example 2

An encapsulant film was manufactured in the same manner as in Comparative Example 1, except that 40 wt% and 60 wt% of LC565 and LC385, respectively, product names of LG Chem, were used as ethylene/alpha-olefin copolymers.

### Comparative Example 3

An encapsulant film was manufactured in the same manner as in Comparative Example 1, except that 60 wt% and 40 wt% of LC565, a product name of LG Chemical, and an ethylene-butene copolymer (MI: 3.6 dg/min, density: 0.885 g/cc, Tg: - 44°C, Tm: 71°C), respectively, were used as the ethylene/alpha-olefin copolymers.

### Comparative Example 4

An encapsulant film was manufactured in the same manner as in Example 1, except that 60 wt% and 40 wt% of LC565, a product of LG Chem, and an ethylene-butene copolymer (MI: 3.6 dg/min, density: 0.885 g/cc, Tg: -44°C, Tm: 71°C), respectively, were used as ethylene/alpha-olefin copolymers.

### Comparative Example 5

An encapsulant film was manufactured in the same manner as in Example 1, except that 60 wt% and 40 wt% of LC565, a product of LG Chem, and an ethylene-butene copolymer (MI: 3.6 dg/min, density: 0.885 g/cc, Tg: -44°C, Tm: 71°C), respectively, were used as ethylene/alpha-olefin copolymers, and BF415, a product of LG Chem, was used as polyethylene.

The composition ratios for the manufacture of the Examples and Comparative Examples are shown in Table 2 below.

**[Table 2]**

| | Ethylene/alpha-olefin copolymer | | | | Polyethylene | |
|---|---|---|---|---|---|---|
| | Preparation Example (wt%) | LC565 (wt%) | LC385 (wt%) | Ethylene-butene copolymer (wt%) | BF315 (phr) | BF415 (phr) |
| Example 1 | Preparation Example 3 (100) | - | - | - | 2 | - |
| Example 2 | Preparation Example 4 (100) | - | - | - | 2 | - |
| Example 3 | Preparation Example 5 (100) | - | - | - | 2 | - |
| Example 4 | - | 60 | 40 | - | 2 | - |
| Example 5 | - | 70 | 30 | - | 2.5 | - |
| Comparative Example 1 | Preparation Example 3 (100) | - | - | - | - | - |
| Comparative Example 2 | - | 40 | 60 | - | - | - |
| Comparative Example 3 | - | 60 | - | 40 | - | - |
| Comparative Example 4 | - | 60 | - | 40 | 2 | - |
| Comparative Example 5 | - | 60 | - | 40 | - | 2 |

### Experimental Example 1

The physical properties of the polyolefin compositions of Examples 1 to 5 and Comparative Examples 1 to 5 were evaluated according to the methods below, and are shown in Tables 3 and 4 below.

### 1) Density of polymer

Measurement was conducted by ASTM D-792.

### 2) Melt Index (MI)

Measurement was conducted by ASTM D-1238 (Condition E, 190°C, 2.16 Kg load).

### 3) Melt flow ratio (MFR)

Calculated as the ratio of the melt index measured by ASTM D-1238 (Condition E, 190°C, 10 kg load) to the melt index measured by ASTM D-1238 (Condition E, 190°C, 2.16 kg load) (MI₁₀/MI_{2.16}).

### 4) Weight average molecular weight (Mw, g/mol) and molecular weight distribution (MWD)

The number average molecular weight (Mn) and weight average molecular weight (Mw) were measured using gel permeation chromatography (GPC), and the molecular weight distribution was calculated by dividing the weight average molecular weight by the number average molecular weight.
- Column: PL Olexis
- Solvent: Trichlorobenzene (TCB)
- Flow rate: 1.0 ml/min
- Sample concentration: 1.0 mg/ml
- Injection volume: 200 µl
- Column temperature: 160°C
- Detector: Agilent High Temperature RI detector
- Standard: Polystyrene (calibrated by a cubic function)

### 5) T(98), T(95), T(90) and T(75)

Obtained by using a successive self-nucleation/annealing (SSA) measurement method using a differential scanning calorimeter (DSC: Differential Scanning Calorimeter 250) manufactured by TA Instrument.

Specifically, in the first cycle, the temperature was increased to 150°C, held at that temperature for 1 minute, and then cooled to -100°C. In the second cycle, the temperature was increased to 120°C, held at that temperature for 30 minutes, and then cooled to -100°C. In the third cycle, the temperature was increased to 110°C, held at that temperature for 30 minutes, and then cooled to -100°C. The process of increasing the temperature at 10°C intervals and cooling to -100°C was repeated up to -60°C to ensure crystallization at each temperature interval.

In the last cycle, the heat capacity was specified while increasing the temperature to 150°C.

The temperature-heat capacity curve obtained in this way was integrated for each section to fractionate the heat capacity of each section against the total heat capacity. Here, the temperature at which 98% of the total melts was defined as T(98), the temperature at which 95% melts was defined as T(95), the temperature at which 90% melts was defined as T(90), and the temperature at which 75% melts was defined as T(75).

**[Table 3]**

| | Density (g/cc) | MI (dg/min) | MFR (dg/min) | Mw (g/mol) | MWD |
|---|---|---|---|---|---|
| Example 1 | 0.880 | 3.6 | 8.1 | 81447 | 2.16 |
| Example 2 | 0.880 | 3.7 | 8.0 | 81235 | 2.15 |
| Example 3 | 0.879 | 2.5 | 9.1 | 85014 | 2.23 |
| Example 4 | 0.874 | 3.7 | 7.9 | 84154 | 2.18 |
| Example 5 | 0.873 | 3.6 | 8.7 | 83076 | 2.2 |
| Comparative Example 1 | 0.877 | 4.4 | 7.6 | 79608 | 2.12 |
| Comparative Example 2 | 0.879 | 3.3 | 7.6 | 84741 | 2.14 |
| Comparative Example 3 | 0.874 | 3.7 | 7.8 | 83160 | 2.12 |
| Comparative Example 4 | 0.876 | 3.3 | 8.3 | 85623 | 2.17 |
| Comparative Example 5 | 0.876 | 3.4 | 8.3 | 83993 | 2.16 |

**[Table 4]**

| | T (75) (°C) | T (90) (°C) | T (95) (°C) | T (98) (°C) | T (90) - T (75) | T (95) T (90) | T (98) T (95) |
|---|---|---|---|---|---|---|---|
| Example 1 | 62.8 | 86.0 | 103.4 | 112.4 | 23.2 | 17.4 | 8.9 |
| Example 2 | 63.2 | 86.2 | 103.4 | 112.8 | 23.0 | 17.2 | 9.4 |
| Example 3 | 63.3 | 87.9 | 103.8 | 113.2 | 24.6 | 15.8 | 9.5 |
| Example 4 | 60.6 | 88.0 | 103.3 | 111.9 | 27.5 | 15.3 | 8.6 |
| Example 5 | 59.1 | 87.2 | 103.3 | 111.0 | 28.2 | 16.1 | 7.7 |
| Comparative Example 1 | 61.4 | 83.8 | 100.5 | 113.3 | 22.4 | 16.7 | 12.7 |
| Comparative Example 2 | 64.2 | 85.5 | 100.7 | 112.4 | 21.3 | 15.2 | 11.7 |
| Comparative Example 3 | 60.9 | 79.6 | 93.9 | 110.4 | 18.6 | 14.3 | 16.5 |
| Comparative Example 4 | 63.5 | 84.8 | 102.9 | 111.1 | 21.2 | 18.1 | 8.2 |
| Comparative Example 5 | 63.7 | 85.8 | 103.8 | 111.6 | 22.1 | 18.0 | 7.8 |

Meanwhile, the results of measurement using the differential scanning calorimetry successive self-nucleation and annealing (SSA) for Example 1 and Comparative Example 1 are shown in the graph in FIG. 1. Referring to FIG. 1, as can be confirmed in Table 2 above, unlike the Comparative Example, the Example has T(90)-T(75) greater than 22°C, T(95)-T(90) less than 18°C, and T(98)-T(95) less than 10°C, so that high crystals, medium crystals, and low crystals are evenly distributed, and it can be confirmed that each crystal is distributed together in some sections and acts as a connecting bridge between each crystal.

### Experimental Example 2

The physical properties of the encapsulant films of Examples 1 to 5 and Comparative Examples 1 to 5 were evaluated according to the methods below, and are shown in Table 5 below.

### 1) Creep characteristics

Each of the encapsulant films of Examples 1 to 5 and Comparative Examples 1 to 5 was cut into 9 cm*9 cm, and two sheets were prepared by overlapping them.

Two 10 cm*12 cm glass plates (low-iron tempered glass) were prepared with a 2 cm margin each so that they overlapped by 10 cm*10 cm, and the overlapping films prepared above were placed therebetween, and then, lamination was performed at 110°C for 15 minutes.

The creep characteristics were confirmed by fixing only one side vertically in an oven and measuring the degree of glass slippage (cm) for 2 weeks at 105°C.

### 2) Adhesive strength

Each of the encapsulant films of Examples 1 to 5 and Comparative Examples 1 to 5 was cut into a size of 10 cm*6 cm, and a release film was cut into 10 cm*7 cm, and they were fixed on a 10 cm*12 cm glass plate (low-iron tempered glass) with the middle 10 cm*1 cm overlapping and covered with a back sheet, and then, lamination was performed at 110°C for 15 minutes. A sample for measuring the adhesive strength was completed by making vertical cuts at 10 cm*1 cm intervals on the laminated sample.

The adhesive strength was measured using a UTM device as the maximum value when the back sheet was gripped and the sample was pulled vertically at a speed of 50 mm/min.

### 3) Light transmittance

The light transmittance at 550 nm was measured using a Shimadzu UV-3600 spectrophotometer (measurement mode: transmittance, wavelength interval: 1 nm, measurement speed: medium).

**[Table 5]**

| | After lamination | | |
|---|---|---|---|
| | Creep (cm) | Adhesive strength (N/10 mm) | Light transmittance (%) |
| Example 1 | 0 | 139 | 89.9 |
| Example 2 | 0 | 143 | 90.2 |
| Example 3 | 0 | 176 | 90.0 |
| Example 4 | 0.1 | 192 | 90.5 |
| Example 5 | 0.1 | 179 | 90.8 |
| Comparative Example 1 | 0.3 | 113 | 90.2 |
| Comparative Example 2 | 0.4 | 149 | 90.0 |
| Comparative Example 3 | 10.0 | 155 | 89.5 |
| Comparative Example 4 | 9.0 | 183 | 89.7 |
| Comparative Example 5 | 8.0 | 193 | 89.8 |

As shown in Table 5 above, it was confirmed that the polyolefin compositions of Examples 1 to 5 had almost no creep phenomenon.

Meanwhile, in Comparative Example 1, polyethylene was not mixed, and the T(98)-T(95) value was greater than 10°C, so that the high crystals were widely spread within the high-crystal region without a specific peak, and thus, the creep phenomenon occurred compared to Example 1. In Comparative Example 2, the section where the high crystals and medium crystals were distributed together was relatively narrow, and the high crystals were widely spread without a specific peak, so that the connection between the crystals was not good, and it was confirmed that the creep phenomenon occurred more frequently.

In the case of Comparative Example 3, an ethylene-butene copolymer with narrow crystal distribution was used, and the polyethylene of high crystals was not used, so the high crystals were widely spread without a specific peak, and thus the creep phenomenon occurred more frequently than in the Examples.

In the cases of Comparative Examples 4 and 5, an ethylene-butene copolymer with narrow crystal distribution was used, and the polyethylene of high crystals was additionally mixed and used, but since there was no distribution point where the high crystals and medium crystals were connected, it was confirmed that the creep phenomenon occurred significantly frequently.

## Claims

1. A composition for an encapsulant film, the composition comprising a polyolefin-based composite satisfying the following conditions (1) to (3), wherein
the polyolefin-based composite comprises one or more olefin-based polymers and polyethylene:
(1) a density is 0.855 g/cc or more, and 0.895 g/cc or less,
(2) a melt index (MI, 190°C, 2.16 kg load condition) is 0.3 dg/min or more, and 40.0 dg/min or less, and
(3) if measured by differential scanning calorimetry successive self-nucleation and annealing (DSC-SSA),
a) $T \left(90\right) - T \left(75\right) > 21.5 ° C ,$
b) $T \left(95\right) - T \left(90\right) < 18 ° C ,$ and
c) $T \left(98\right) - T \left(95\right) < 10 ° C ,$
where T(98), T(95), T(90), and T(75) are temperatures at which heat capacity reaches 98%, 95%, 90%, and 75%, respectively, if a temperature-heat capacity curve measured by differential scanning calorimetry successive self-nucleation and annealing (DSC-SSA) is fractionated.

2. The composition for an encapsulant film according to claim 1, wherein the polyolefin-based composite satisfies the following condition (4):
(4) a melt flow rate ratio (MFRR, MI₁₀/MI_{2.16}) is 7.5 or more, and 9.5 or less.

3. The composition for an encapsulant film according to claim 1, wherein the polyolefin-based composite satisfies the following condition (5):
(5) a weight average molecular weight is 10,000 g/mol or more, and 500,000 g/mol or less.

4. The composition for an encapsulant film according to claim 1, wherein the polyolefin-based composite satisfies the following condition (6):
(6) molecular weight distribution is 1.5 or more, and 3.0 or less.

5. The composition for an encapsulant film according to claim 1, wherein T(95) is 100°C or higher, and 110°C or lower.

6. The composition for an encapsulant film according to claim 1, wherein T(90) is 85.9°C or higher.

7. The composition for an encapsulant film according to claim 1, wherein the polyethylene is comprised in 1 part by weight or more, and 5 parts by weight or less based on 100 parts by weight of the olefin-based polymer.

8. The composition for an encapsulant film according to claim 1, wherein
the one or more olefin-based polymers comprise a first olefin-based polymer and a second olefin-based polymer, and
a weight ratio of the first olefin-based polymer and the second olefin-based polymer is 1:0.1 or more, and 1 or less.

9. The composition for an encapsulant film according to claim 1, wherein the olefin-based polymer is a copolymer of ethylene and an alpha-olefin comonomer.

10. The composition for an encapsulant film according to claim 9, wherein the alpha-olefin comonomer is an alpha-olefin comonomer of 3 to 12 carbon atoms.

11. The composition for an encapsulant film according to claim 10, wherein the alpha-olefin comonomer comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, norbornene, norbornadiene, ethylidenenorbornene, phenylnorbornene, vinylnorbornene, dicyclopentadiene, 1,4-butadiene, 1,5-pentadiene, 1,6-hexadiene, styrene, alpha-methylstyrene, divinylbenzene, and 3-chloromethylstyrene.

12. An encapsulant film formed using the composition for an encapsulant film according to any one of claims 1 to 11.

13. A solar cell module comprising the encapsulant film of claim 12.
